# EUROPEAN PATENT SPECIFICATION

(11) **EP 3 271 954 B1**
(45) Date of publication and mention of the grant of the patent: **15.07.2020**
(21) Application number: 16713795.9
(22) Date of filing: 21.03.2016
(51) Int. Cl.: H01L 35/16, H01L 35/24, H01L 35/26, H01L 35/34

(54) **COMPOSITE MATERIAL FOR THERMOELECTRIC DEVICES**
VERBUNDWERKSTOFF FÜR THERMOELEKTRISCHE GERÄTE
MATÉRIAU COMPOSITE POUR DES APPAREILS THERMOÉLECTRIQUES

(30) Priority: 19.03.2015 EP 15159968
(43) Date of publication of application: 24.01.2018
(73) Proprietor: Rockwool International A/S, 2640 Hedehusene (DK)
(72) Inventor: SANTAMARIA RAZO, Diego, 5643 PB Eindhoven (NL); ZONNEVELD, Yoran, 5611 BE Eindhoven (NL); ROCCA, Fabrizio, 10071 Borgaro Torinese (IT); TONDELLA, Andrea, 13886 Viverone (IT)
(74) Representative: Gill Jennings & Every LLP
(86) International application number: PCT/EP2016/056172
(87) International publication number: WO 2016/146855

(56) References cited:
- WO-A1-2014/008414
- JP-A- 2007 240 470
- US-A- 5 017 420
- US-A1- 2004 109 666
- US-A1- 2011 168 440
- US-A1- 2013 084 464

## Description

### Field of the invention

The invention relates to a composite material exhibiting thermoelectric properties, a method of making such a material and products using this material.

### Background of the invention

The invention is in the field of thermoelectric materials: materials that are able to convert a temperature difference to a voltage difference and vice versa. An ideal thermoelectric material is an excellent thermal insulator whilst also being an excellent electrical conductor. Materials that exhibit these thermoelectric properties can be difficult to synthesise and are often prohibitively expensive for widespread use. Such materials often contain toxic metals such as lead as described in WO2014/0144477. The difficulty lies in the fact that materials that are excellent electrical conductors are usually also excellent thermal conductors, such as metals. Likewise, thermal insulators are usually also electrical insulators, for example many common polymeric materials such as polyethylene.

A thermoelectric material can generate a voltage when a temperature difference exists across the material. At the hotter side, there is a higher chance that electrons will fill the higher energy states. At the colder side, the chance is lower that electrons will move to a higher energy state. The result of this is that the hotter side has higher electron occupation per state at high energy levels and lower electron occupation per state at lower energy levels when compared to the colder side. The difference in chemical potential causes lower energy carriers to drift to the hotter side and higher energy carriers to drift to the colder side. Electrical potential difference (voltage) is observed when these drifts are unequal. Asymmetric drift can occur due to, for example, a difference in scattering rates, a difference in speeds, a difference in density of states, or a combination of these effects. This phenomenon enables the conversion of a temperature difference to an electrical potential difference. Meanwhile, thermoelectric crystalline ceramics exhibit a high degree of phonon scattering, which reduces the thermal conductivity. These two effects - voltage generation and thermal insulation - together produce a crystal that exhibits a thermoelectric effect.

The Seebeck coefficient, S, is a material constant that determines the relationship between ΔT and ΔV for a particular material according to the formula S = -ΔV/ΔT. Accordingly, S has units of V/K, where V is Voltage and K is temperature in Kelvin. A positive Seebeck coefficient indicates that the charge carriers are positive, such as holes. Conversely, a negative Seebeck coefficient indicates that the charge carriers are negative, such as electrons. The larger the absolute value of the Seebeck coefficient, the better the material is at transforming a temperature difference to an electrical potential difference. Related to the Seebeck effect, the Peltier effect occurs where a material is able to transform an electrical potential difference into a temperature difference. For time-reversal symmetric materials, the relation between the effects is linked according to the formula Π = T·S, where Π is the Peltier coefficient, T is the absolute temperature and S is the Seebeck coefficient and vice versa.

However, a Seebeck coefficient of large absolute value alone is insufficient to achieve a high efficiency of conversion between temperature and electrical potential. Instead, the dimensionless figure of merit, written as zT or ZT, is used to measure how well a thermoelectric material performs. The best thermoelectric materials will have both a high Seebeck coefficient and a high figure of merit. The figure of merit is calculated according to the formula zT = S²σT/κ, where S is the Seebeck coefficient, σ is the electrical conductivity, T is the absolute temperature and κ is the thermal conductivity. In a composite, therefore, a high zT may be achieved even where the component parts have Seebeck coefficients of opposing signs, since the electrical conductivity of the material also plays a part in determining the composite's overall effectiveness as a thermoelectric material.

A known thermoelectric material that is found in nature is tetrahedrite. Tetrahedrite has the general formula Cu₁₂₋ₓMₓSb₄S₁₃, where 0 ≤ x ≤ 3 and M is usually one or more of Fe, Zn, Ag and Mn. Tetrahedrite is a naturally occurring material found at various locations globally, particularly in copper and silver mines.

Efforts have been made to characterise the thermoelectric effect in synthetic tetrahedrite of various chemical compositions. For example, Suekuni *et al*., "Thermoelectric properties of mineral tetrahedrites Cu₁₀*Tr*₂Sb₄S₁₃ with low thermal conductivity", Applied Physics Express 5 (2012) 051201 investigates the thermoelectric properties of synthetic tetrahedrites of general formula Cu₁₀*Tr*₂Sb₄S₁₃ (*Tr* = Mn, Fe, Co, Ni, Cu and Zn). The aim of the paper is to characterise these compounds in their pure form to investigate their substitutability for thermoelectric materials that contain toxic elements such as lead.

Further research efforts in the field of tetrahedrites aim to synthesise and characterise hybrid natural-synthetic tetrahedrites. For example, Lu et al., "Natural mineral tetrahedrite as a direct source of thermoelectric materials", Phys. Chem. Chem. Phys., 2013, 15, 5762-5766 investigates the thermoelectric properties of samples containing a mixture of synthetic tetrahedrite (Cu₁₂Sb₄S₁₃) and natural mineral tetrahedrite (as-mined, with impurities and compositional variation) or related natural mineral tennantite, in which the antimony of tetrahedrite is substituted by arsenic. Tetrahedrite and tennantite samples were prepared using milling and hot pressing. The study investigates these samples in isolation and measures the figure of merit for various synthetic to natural mineral ratios.

These do not present ways to utilise the materials in a practical sense and do not present a way to use unrefined raw materials that comprise tetrahedrite for a useful thermoelectric effect.

Some practical uses of tetrahedrites have been explored in other studies. WO2014/008414 describes the use of tetrahedrite in a device, wherein a layer of tetrahedrite is sandwiched between a pair of conductors, requiring a substantial amount of tetrahedrite. Not only does this require a substantial amount of tetrahedrite, it is also limited in application by the need for a bulk portion of tetrahedrite in direct contact with a pair of conductors. In common with most ceramics, tetrahedrite in bulk is brittle. Such a property is disadvantageous in applications where a fast temperature change may occur and where high impact forces are experienced.

Another laminar application of thermoelectric materials is described in US2013/084464. This document discloses a thermoelectric composite material comprising alternating layers of an inorganic nanostructure and an electrically conductive organic polymer. The inorganic nanostructure comprises a single metal or metalloid, bimetal, metal-metalloid compound or metal-non-metal compound and has a layered crystal structure. Thermoelectric activity is anticipated from both the inorganic nanostructure and the organic polymer heterostructure.

US2014/116491 discloses a different approach to making a bulk thermoelectric solid. In this document, silicon nanowires or, alternatively, silicon nanograins are sintered to create a bulk thermoelectric solid. This is a thermoelectric material due to silicon's performance as an electrical semiconductor and a thermal insulator. The top and bottom can be metallised and annealed to form conductive contacts. Silicon nanowires are a costly and environmentally disadvantageous material choice, since the nanowires must be first produced by etching bulk crystalline silicon.

Thermoelectric composites have been explored for their potential application in a photovoltaic solar panel setting, to utilise the heat on the underside of such panels that is currently wasted. To this end, a flexible thermoelectric composite is described in JP2014-29932A. The composite is achieved by mixing a polymer, preferably PTFE, with a conductive material, preferably carbon nanofibres or nanotubes, and a thermoelectric material. Semiconductors such as Si are suggested for use in the thermoelectric material.

Flexible thermoelectric composites are further explored in US2014/144477. This document details how the problem of rigidity of known thermoelectric materials can be overcome by utilising nanocrystalline samples of these materials rather than bulk. In particular, nanocrystalline lead telluride is utilised as the thermoelectric component, coated onto a flexible substrate such as bare glass fibres.

There is a need for a thermoelectric material that is low cost. Further, there is a need for a thermoelectric material which uses abundant materials. There is a need for a thermoelectric material which is non-toxic and environmentally friendly. Further, there is a need for a thermoelectric material which exhibits good mechanical properties, such as strength and toughness. Additionally, there is a need for a thermoelectric material that is easy to process and to produce a product therefrom. Further, there is a need for a thermoelectric material which produces both voltage and current. The present invention solves these problems.

### Summary of invention

A first aspect of the invention provides a composite according to claim 1.

A second aspect of the invention provides a method of making a composite, according to claim 11.

The method of the invention may further comprise any of the features of the embodiments of the composite of the invention.

A third aspect of the invention provides a friction material comprising the composite of the first aspect of the invention, preferably wherein the friction material is an automotive friction material, more preferably wherein the friction material is a brake pad.

A fourth aspect of the invention provides a thermoelectric device comprising the composite of the first aspect of the invention, wherein the composite is disposed between a pair of conductors.

### Brief description of drawings

Figure 1 shows a schematic cross-sectional view a coated fibre (5), comprising a fibre (1) coated with an electrically conductive polymer (2) and mixed with a thermoelectric material (3) and a binder (4).
Figure 2 shows a schematic cross-sectional view of a coated fibre (6), comprising a fibre (1) coated with an electrically conductive polymer (2), a thermoelectric material (3) mixed into the electrically conductive polymer (2), and a binder (4).
Figure 3 shows a schematic view of a composite (7) comprising a network of coated fibres (5).
Figure 4 shows a schematic view of a composite (8) comprising a network of coated fibres (6).

### Detailed description

Thermoelectric materials comprising a metal sulphosalt are in ready supply, predominantly as a by-product of copper mining. Electrically conductive polymers do not utilise low-abundance or toxic metals and the starting materials are similarly in ready supply. Likewise, fibres suitable for use in this invention are in ready supply and in some embodiments are either naturally occurring fibres or fibres synthesised from waste materials that are otherwise difficult to dispose of. Use of these materials in a composite achieves a good balance of thermoelectric and mechanical performance of the finished product compared to the starting materials. Furthermore, the environmental impact of the thermoelectric composite is lower than synthetic thermoelectric materials known in the art.

The composite of the invention shows thermoelectric performance. This means that it can convert a difference in temperature to an electrical potential difference, i.e. a voltage. This performance is surprising for a bulk material that comprises other components in addition to pure thermoelectric materials. Further, the composite may produce both voltage and current. Furthermore, the composite is able to utilise abundant, naturally occurring materials. The composite overall is a lower cost alternative to using pure thermoelectric materials and has the advantage of good mechanical performance, such as strength and toughness. Compared to many of the thermoelectric materials known in the art, the composite of this invention is of low or no toxicity and environmentally friendly. The method of making the composite material offers environmental benefits due to its suitability for use with abundant, naturally occurring materials that require little processing.

Preferably the composite has a density in the range 0.5 to 7 cm³, preferably 1.6 to 4.5 cm³. Such densities give the strength required of the composite.

Preferably the porosity of the composite has a porosity in the range of 4 to 30%, preferably 8 to 25%. If the porosity is higher than these values, the composite may not conduct electricity.

### THERMOELECTRIC MATERIAL

A thermoelectric material is able to convert a temperature difference to an electrical potential difference (a voltage). The ideal thermoelectric material is both thermally insulating and electrically conducting. A thermal insulator preferably has a thermal conductivity below 3 W/mK. An electrical conductor preferably has an electrical conductivity above 0.001 S/m.

In the claimed composite, a thermoelectric material is required in order to achieve a useful thermoelectric effect. A composite comprising an electrically conductive polymer and fibres in the absence of a thermoelectric component has a figure of merit and Seebeck coefficient of low value. Electrically conductive polymers alone exhibit a low thermoelectric effect, but the mechanical properties of these polymers limit their use. Some fibres, such as carbon fibres, alone may also exhibit a thermoelectric effect, but such fibres alone also have limited use due to their mechanical properties.

Metal sulphosalts, such as tetrahedrite, are abundant in the Earth's crust and are found in waste material from copper and silver mines. Such material is often disposed of in landfill, so use of this material with minimal processing has the double environmental benefit of reducing waste from mining and reducing energy consumption in the production of thermoelectric composites.

Tetrahedrite is found in raw materials such as copper ores. Copper, silver and lead concentrates - man-made by-products from production of copper, silver and lead from their respective ores - also contain tetrahedrite. In these materials, tetrahedrite is present in solid solution with other sulphosalts such as tennantite and/or freibergite.

Copper concentrate is a refined copper mining by-product. Waste material from copper ore extracted is refined to remove some impurities, resulting in a material with a higher concentration of useful components such as tetrahedrite. A copper concentrate suitable for use as the thermoelectric material in this invention comprises tetrahedrite, chalcopyrite (CuFeS₂), geerite (Cu₈S₅) and lead sulphide (PbS).

Tetrahedrite exhibits a thermoelectric effect, as do other metal sulphosalts, in particular copper sulphosalts and silver sulphosalts. The inventors have found that, surprisingly, such raw materials and copper and silver concentrates may be used as the predominant thermoelectric component in a composite with minimal processing beyond crushing and still give a thermoelectric effect to the composite as a whole.

In its pure form, tetrahedrite has the general formula Cu₁₂₋ₓMₓSb₄S₁₃. M is usually one or more of Fe, Zn, Ag and Mn and usually 0 ≤ x ≤ 3. Usually, 0 ≤ Fe ≤ 3, 0 ≤ Zn ≤ 3, 0 ≤ Ag ≤ 3 and 0 ≤ Mn ≤ 3. In solid solution, tetrahedrite can be found in general form Cu₁₂₋ₓMₓSb_{4-y}Sn_{y}S₁₃, where usually 0 ≤ x ≤ 3 and 0 ≤ y < 4. Where y = 4, the material is tennantite; where y = 0, the material is tetrahedrite and where 0 < y < 4, the material is a solid solution of tetrahedrite and tennantite. In the raw material such as waste from a copper mine, other minerals and impurities are also present.

The metal sulphosalt in this invention can comprise a copper or silver sulphosalt, preferably a copper sulphosalt. These compounds are found in nature, offering economic and environmental benefit to the invention.

The metal sulphosalt comprises a compound comprising a metal, a semimetal and sulphur. Preferably the semimetal is selected from antimony, arsenic, tellurium, germanium, silicon, boron, or a mixture thereof, more preferably antimony, arsenic or a mixture thereof, more preferably antimony.

The metal sulphosalt may comprise tetrahedrite of the formula Cu₁₂₋ₓMₓSb_{4-y}As_{y}S₁₃, wherein 0 ≤ x ≤ 3, 0 ≤ y < 4 and M is Ag, Zn, Fe, Mn or combinations thereof, preferably wherein the metal sulphosalt comprises tetrahedrite of the formula Cu₁₂₋ₓMₓSb₄S₁₃, wherein 0 ≤ x ≤ 3 and M is Ag, Zn, Fe, Mn or combinations thereof. In some embodiments, M may further comprise Hg, although this is less preferred due to environmental and health concerns. The tetrahedrite may be in a solid solution. Tetrahedrite and its solid solutions with other metal sulphosalts are also found in nature, offering economic and environmental benefit to the invention.

In one embodiment, the metal sulphosalt does not comprise tetrahedrite of the formula Cu₁₂₋ₓMₓSb_{4-y}As_{y}S₁₃, wherein 0 ≤ x ≤ 3, 0 ≤ y < 4 and M is Ag, Zn, Fe, Mn or combinations thereof.

In a further embodiment, the metal sulphosalt does not comprise tetrahedrite of the formula Cu₁₂₋ₓMₓSb₄S₁₃, wherein 0 ≤ x ≤ 3 and M is Ag, Zn, Fe, Mn or combinations thereof.

The thermoelectric material is in the form of particles, wherein the particles have a mean particle diameter of at least 50 nm, such as at least 250 nm or at least 10 µm. If the particles are very small, the energy consumption to crush them becomes high. Additionally, very fine particulates in general can carry respiratory health risks.

The thermoelectric material is in the form of particles, wherein the particles have a mean particle diameter of no more than 250 µm, preferably no more than 100 µm, more preferably no more than 50 µm. If the particles are too large, they become difficult to disperse in the electrically conductive polymer.

The particles may take any shape. The particles may be produced from bulk material by crushing and sieving.

The thermoelectric material is present in an amount of at least 5 wt% of the composite, preferably at least 20 wt% of the composite. If there is too little of the thermoelectric material present in the composite, the thermoelectric performance of the composite will be poor.

The thermoelectric material is present in an amount of no more than 70 wt% of the composite, preferably no more than 60 wt%, of the composite. If there is too much of the thermoelectric material present in the composite, the composite will be too brittle for some practical uses such as brake pads.

In a preferred embodiment, at least 1.0 wt% of the thermoelectric material is tetrahedrite of the formula Cu₁₂₋ₓMₓSb₄S₁₃, wherein 0 ≤ x ≤ 3 and M is Ag, Fe, Zn, Mn, or combinations thereof. Preferably, M is 0 ≤ Ag ≤ 3, 0 ≤ Zn ≤ 3, 0 ≤ Fe ≤ 3, or combinations thereof. More preferably, M is 0 ≤ Ag ≤ 1, 0 ≤ Zn ≤ 1.5, 0 ≤ Fe ≤ 3, or combinations thereof. The tetrahedrite may be naturally occurring or synthetic.

In the case where synthetic tetrahedrite is used, the composition may be fine-tuned as required to optimise the thermoelectric performance. In the case where naturally occurring tetrahedrite is used, the cost and the energy consumption to make the composite are both decreased.

Tetrahedrite commonly forms solid solutions with tennantite and freibergite. Related compounds that may be present in the raw material alongside tetrahedrite, tennantite and freibergite include galena, chalcopyrite, sphalerite, pyrite and pyrrhotite. Other compounds, such as impurities, may also be present. In one example, a copper concentrate suitable for use in this invention includes chalcopyrite (CuFeS₂), geerite (Cu₈S₅), galena (PbS) alongside tetrahedrite. The exact composition of the raw material varies according to where it was mined.

Unfortunately, both synthetic tetrahedrite and raw material containing tetrahedrite are too brittle for widespread application. The composite of this invention harnesses the thermoelectric effect of tetrahedrite whilst providing improved mechanical properties such as strength and toughness compared to tetrahedrite or raw material alone.

### ELECTRICALLY CONDUCTIVE POLYMER

Certain polymers exhibit electrical conductivity. Electrical conductivity in polymers is commonly achieved in one of two ways.

The first way is to add a filler to an otherwise electrically insulating polymer.

Suitable fillers include carbon black, graphite, graphene nanosheet, expanded graphite, aluminium, copper, indium tin oxide, copper nanowire, carbon nanotubes, steel fibres, bismuth telluride and lamellar oxides such as micaceous iron oxide. Preferred conductive fillers may be carbon black, graphite, graphene nanosheet, expanded graphite, carbon nanotubes, copper and copper nanowire. More preferred fillers may be carbon black, graphite, graphene nanosheet, expanded graphite and carbon nanotubes. Most preferably, the filler may be carbon black.

The conductive filler may be present in the electrically conductive polymer in an amount of at least 20 wt%, preferably at least 25 wt%, more preferably at least 30 wt%. Less than this amount may result in too low electrical conductivity of the final composite. The conductive filler may be present in the electrically conductive polymer in an amount of no more than 50 wt%, preferably no more than 45 wt%, more preferably no more than 40 wt%. More than this amount of filler may result in agglomeration and saturation of the filler. For example, the filler may be present in an amount of about 30 wt% of the electrically conductive polymer. The optimum amount of filler balances high electrical conductivity with ease of production and avoidance of agglomeration.

Suitable polymers for use with electrically conductive fillers include silicone resin, styrene-butadiene rubber (SBR), epoxy resin, acrylonitrile butadiene styrene, poly(ether ether ketone), polyethylene, maleic anhydride, polyamide, polycarbonate, poly(ethylene terephthalate), poly(methyl methacrylate), polypropylene, poly(phenylene sulphide), polyvinylacetate, polyvinyl chloride, polybinylidene fluoride, poly(styrene-co-acrylonitrile), polyurethane, latex and nitril rubber.

Preferably a silicone rubber polymer and a carbon black filler are used as the conductive polymer.

The second way is to dope a conjugated polymer to transform it from an electrical semiconductor or insulator to a conductor. The dopant acts by either oxidising or reducing the polymer. Suitable dopants include acids and bases, for example organic acids and bases. Specific suitable dopants include dodecylbenzene sulphonic acid (DBSA), p-toluenesulphonic acid, camphor-10-sulphonic acid, dinonylnaphthalenesulphonic acid, benzoquinone and HClO₄. Suitable polymers for use with dopants include polypyrrole, polyaniline, polythiophenes, polyacetylenes, polyfluorines, polyphenylenes, polypyrenes, polyazulenes, polynaphthalenes, polycarbazoles, polyindoles, polyazepines, poly(p-phenylene vinylene) and poly(3,4-ethylenedioxythiophene)poly(styrenesulphonate) (PEDOT:PSS).

In this invention, the electrically conductive polymer plays an important role in increasing the figure of merit. A composite of thermoelectric material and fibres in the absence of the electrically conductive polymer has a high Seebeck coefficient but a low figure of merit, since the overall conductivity is low and the voltage generated is localised at disconnected particles of thermoelectric material. The electrically conductive polymer solves this deficiency.

The fibres are at least partially coated with the electrically conductive polymer. A coating is distinguished from a bulk material or binder in that it is localised to the material to be coated. For example, in a bulk sample of polymer with fibre reinforcement, the fibres are not considered to be coated with the polymer. Instead, the fibres are considered to be dispersed in the polymer. An advantage of the electrically conductive polymer coating the fibres is that less polymer is required than if there is a bulk sample of polymer with fibre reinforcements. The fibres provide a network through the composite and coating the fibres with an electrically conductive polymer means that the composite can conduct electricity.

Furthermore, a coating may be considered to be finite in size relative to the material to be coated, unlike in the case where a material is dispersed in a bulk polymer. In the present invention, where the electrically conductive polymer coats the fibres, the electrically conductive polymer coating may have a thickness in the range 50 nm to 100 µm. If the coating is less than 50 nm it may not be thick enough to provide a network to conduct electricity through the polymer. If the coating is greater than 100 µm, then more electrically conducting polymer is required than necessary for the technical effect.

The coating may be continuous along each fibre such that the outside surface of each fibre is completely covered with electrically conductive polymer. This has the advantage of maximising the electrically conductive network though the composite.

Alternatively, the fibres may be partially coated with the electrically conductive polymer. This has the advantage of requiring less polymer. If the fibres are partially coated with the electrically conductive polymer, there should be a network of electrically conductive polymer through the composite to allow the composite as a whole to conduct electricity.

The electrically conductive polymer may comprise a doped polymer; a filled, non-doped polymer; or mixtures thereof. Where the polymer is not a doped polymer, the filler lends electrical conductivity to the polymer. The polymer must be electrically conductive, since the fibres of the composite are not necessarily electrically conductive and the thermoelectric material is not necessarily in continuous contact throughout.

The thermoelectric material may be mixed into the electrically conductive polymer. This affords better contact between the thermoelectric material and the electrically conductive polymer and a more uniform thermoelectric performance of the composite.

The electrically conductive polymer may be present in an amount of at least 0.1 wt% of the composite, such as at least 3 wt% of the composite. If too little electrically conductive polymer is included in the composite, the fibres will not be sufficiently coated and a continuous electrically conductive network will not be formed.

The electrically conductive polymer may be present in an amount of no more than 25 wt% of the composite, for example no more than 15 wt% of the composite, such as no more than 10 wt% of the composite. If too much electrically conductive polymer is included in the composite, the mechanical performance of the composite may worsen.

### FIBRES

The fibres of the present invention also play a key role in the composite. A composite of the thermoelectric material and the electrically conductive polymer in the absence of fibres has poor mechanical properties, such as notch toughness, hardness, compression strength and overall friction performance. In particular, in the absence of fibres the composite would have a very low toughness. Importantly, electrical conductivity of the composite is decreased when the fibres are not present compared to when fibres are present and coated with the electrically conductive polymer, despite the fact that the fibres by themselves when not coated are not necessarily electrically conductive. This is because the fibres act as a scaffold for the electrically conductive polymer to form a continuous electrically conductive network.

The fibres may be selected from synthetic inorganic fibres, natural inorganic fibres and carbon fibres. Preferably the fibres may be selected from synthetic and natural inorganic fibres. More preferably, the fibres may be synthetic inorganic vitreous fibres or natural inorganic fibres. In another alternative, the fibres may be a synthetic vitreous fibre. Specifically, the fibres may be synthetic inorganic vitreous wool fibres.

As examples: synthetic inorganic fibres include mineral wool, stone wool, potassium titanate, glass wool and basalt fibre; natural inorganic fibres include wollastonite; synthetic inorganic vitreous fibres include mineral wool, stone wool, basalt fibre and glass wool; man-made vitreous fibres (MMVF) include mineral wool, stone wool, glass wool and slag wool.

In one embodiment the fibres are man-made vitreous fibres (MMVF).

Where man-made vitreous fibres (MMVF) are used, the fibres may contain shots. Preferably, the amount of shots is low, for example 0.1 wt% of the fibres may be shots. Shots are solid charge with a particle diameter of greater than 63 µm.

MMVF preferably are stone wool fibres and preferably have a composition as follows, all values quoted as wt%:
SiO₂25 to 50, preferably 38 to 48, more preferably 37 to 42
Al₂O₃ 4 to 30, preferably 15 to 28, more preferably 18 to 23
TiO₂ up to 6
Fe₂O₃ 2 to 15
CaO 5 to 30, preferably 5 to 18
MgO up to 20, preferably 1 to 8
Na₂O 0 to 15
K₂O 0 to 15
P₂O₅ up to 3
MnO up to 3
B₂O₃ up to 3

The diameter of the fibres may be at least 0.5 µm, such as at least 2 µm. The diameter of the fibres may be no more than 30 µm, such as no more than 8 µm. The length of the fibres can be 1 µm to 6 mm.

The fibres may be present in an amount of at least 0.1 wt% of the composite, such as at least 10 wt% of the composite, or at least 25 wt% of the composite. If no fibres are present, or if too few fibres are present, the thermal insulation performance of the composite may be worsened. Additionally, if an insufficient amount of fibres is present, a scaffold network for the electrically conductive polymer may not form.

The fibres may be present in an amount of no more than 75 wt% of the composite, such as no more than 70 wt% of the composite, or no more than 60 wt% of the composite. If too many fibres are present, the amount of electrically conductive polymer and thermoelectric material may be insufficient to achieve good thermoelectric performance of the composite.

### BINDER

The composite may optionally further comprise a binder. A binder may be added to the composite for applications where it is desirable to obtain a compact composite product with minimal damage to the continuous network during pressing.

Prior to any curing step, the binder may be present in an amount of at least 0.1 wt% of the composite, such as at least 3 wt% of the composite. Binder in this amount can help to increase the mechanical strength of the composite.

Prior to any curing step, the binder may be present in an amount of no more than 10 wt% of the composite, such as no more than 7 wt% of the composite. In larger quantities, binder can decrease the overall electrical conductivity and thus worsen the thermoelectric performance of the composite.

Binders that can be used in this invention include phenolic, silicon, concrete, rubber and epoxy binders.

The binder may be a powder binder. Powder binders suitable for use in this invention typically have micron-scale powder particles.

The binder may be present in an amount of no more than 10 wt% of the final composite, preferably no more than 8 wt%, for example no more than 6 wt%. The binder may be present in an amount of at least 3 wt%, preferably at least 4 wt%. These amounts may optimise the mechanical properties of the final composite, increase its electrical conductivity and lower its porosity.

### FORMULATION METHODS

To make the composite of the invention, a thermoelectric material, an electrically conductive polymer and fibres are mixed and formed into a composite.

The mixture may be formed into a composite by hot pressing. Hot pressing has the advantage that, if a binder is used, the heat can partially or wholly cure the binder. Alternatively, a cold press may be used followed by a curing process if a binder is present.

Hot pressing is carried out using a hot press. In this invention, a pressure of 50-500 kg/cm² may be used. A temperature of 75-200 °C may be used. The dwell time of the composite in the hot press may be 1-10 minutes. For example, a temperature of 165°C and a pressure of 250 kg/cm², for a period of 6 minutes may be suitable. Where a binder is used, curing may also be performed. The hot press may be used to cure the binder at the same time as forming the composite. A separate curing step after the hot press may also be used. A temperature of 100-300°C and a time of 1-5 hours at the specified curing temperature can be used, for example curing for 2 hours at a temperature of 175°C, for the optional curing step. The total curing time will be longer, due to the fact that the oven needs to start at room temperature and gradually increases to the desired curing temperature. Cold pressing is typically carried out at approximately 90°C.

The mixing step may comprise the following stages: coating the fibres with the electrically conductive polymer to form coated fibres; and mixing the coated fibres with the thermoelectric material and optional binder. This method allows larger particles of the thermoelectric material to use, reducing the amount of crushing required.

Alternatively, the mixing step may comprise the following stages: mixing the thermoelectric material and the electrically conductive polymer to form a dispersion of thermoelectric material in the electrically conductive polymer; coating the fibres with the dispersion to form coated fibres; optionally mixing the coated fibres with the binder. This method achieves good contact between the electrically conductive polymer and the fibres and more uniform thermoelectric performance.

In another embodiment, the mixing step may comprise the following stages: mixing the thermoelectric material and the binder to form a thermoelectric binder; mixing the thermoelectric binder with the fibres and the electrically conductive polymer. Where a binder is used, mixing it with the thermoelectric material before mixing with the other components improves the homogeneity of dispersion of the binder in the composite.

The method of the invention may further comprise the step of curing the composition after forming the mixture into a composite. Where the binder is included, the cured composite has improved mechanical performance.

The fibres may be coated with the electrically conductive polymer. A way to do this is by mixing the fibres and a solution of the polymer in a standard mixer, such as those available from Mischtechnik International GmbH (Germany). Another way to coat the fibres with the electrically conductive polymer is to mix the fibres with the electrically conductive polymer in its melt state.

### APPLICATIONS OF THE INVENTION

A potential application of the composite of this invention is in friction applications, in particular in the automotive field for use in brake pad and clutch facings, more specifically for brake pads for electric cars. Electric cars must travel as far as possible on one charge in order to be an attractive alternative for consumers to combustion engine cars. Thus it is desirable to waste as little energy as possible and to harness energy from other sources.

Engine braking allows some energy to be recovered. Braking must be completed by traditional friction braking, however, so a brake pad material that is able to deliver further energy back to the engine is highly attractive for manufactures of automotives, particularly electric cars. Traditional automotive friction braking occurs in short spaces of time and results in a fast temperature increase at the braking interface. A material that meets the existing requirements for automotive brake pads as well as exhibiting thermoelectric properties would be able to utilise the high temperature differential between the braking surface and the surroundings to generate an electrical potential difference. The potential difference can then either be used immediately, or converted into current and stored for future use. The present invention provides an ideal composite material to use as a friction material and to allow electrical energy to be harvested from the temperature difference created by the friction material, for instance by braking.

### TEST METHODS

Thermal conductivity can be calculated from the thermal diffusivity, specific heat and density. Thermal diffusivity can be measured using the laser flash method ASTM E1461-13. Specific heat can be measured with a suitable calorimeter. Thermal conductivity is calculated according to the following equation:
D = k/(c·d), where D is thermal diffusivity (mm²/s), k is thermal conductivity (W/(m·K)), c is heat capacity (specific heat) (J/(kg·K)), and d is density (kg/m³).

Electrical conductivity can be measured using the four point probe method, ASTM F390-11.

Temperature must be measured on both the hot and cold (relative) sides of the sample. Any suitable temperature gauge known in the art may be used, such as a K-type thermocouple.

Potential difference (voltage) must be measured at the same distance apart as the temperature, across the sample. Any suitable voltmeter may be used.

Current must be measured at the same distance apart as the temperature, across the sample. Any suitable ammeter may be used.

Mean particle diameter can be controlled by sieving.

Fibre diameter can be measured optically, by known methods, such as described in Koenig et al., Analytica Chimica Acta, 1993, Vol. 280, pages 289-298 and in Christensen et al., American Industrial Hygiene Association Journal, Vol. 54, 5, 1993.

Coating thickness can be measured optically in a similar manner.

### Detailed Description of Drawings

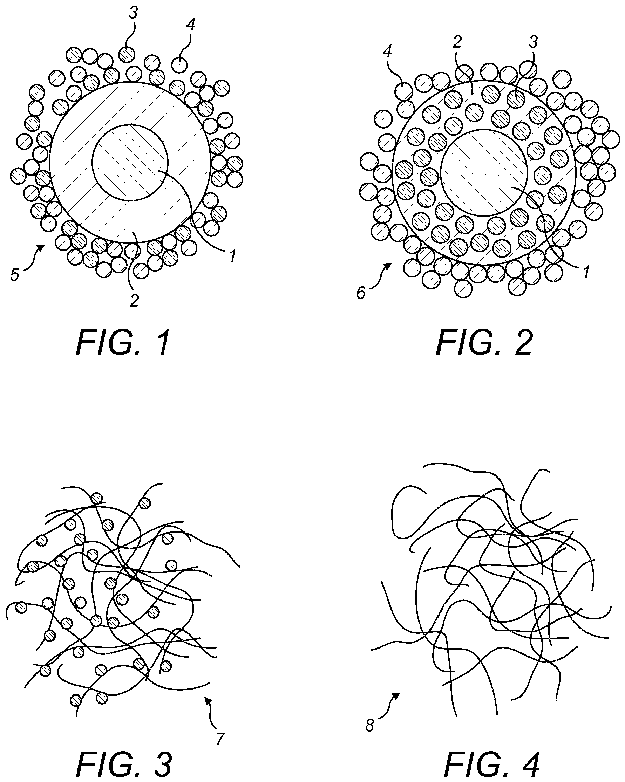

Figure 1 shows a schematic cross-sectional view of a coated fibre (5), comprising a fibre (1) coated with an electrically conductive polymer (2) and mixed with a thermoelectric material (3) and a binder (4).
Figure 2 shows a schematic cross-sectional view of a coated fibre (6), comprising a fibre (1) coated with an electrically conductive polymer (2), wherein a thermoelectric material (3) is mixed into the electrically conductive polymer (2), the coated fibre mixed with a binder (4).
Figure 3 shows a schematic view of a composite (7) comprising a network of coated fibres (5). The fibres are coated with an electrically conductive polymer. The coated fibres form a scaffold for the electrically conductive polymer which allows the composite to conduct electricity. A thermoelectric material is dispersed through the composite.
Figure 4 shows a schematic view of a composite (8) comprising a network of coated fibres (6). The fibres are coated with an electrically conductive polymer. The coated fibres form a scaffold for the electrically conductive polymer which allows the composite to conduct electricity. A thermoelectric material is dispersed in the coating of the fibres.

### Examples

Test samples according to the invention and for comparison were made by mixing the components as listed in table 1 in a mixer. After mixing, the mixture was subjected to a hot press to form a compact sample.

Compact samples were mixed with binder and subjected to a hot press. The conditions used in this example were 165°C and 102 kg/cm². Curing occurred over 8 hours at a temperature that increased from 25 to 170°C. The last hour of the cycle was at 170°C.

Examples 1 and 2 are according to the invention and demonstrate the thermoelectric performance of the composite. The Seebeck coefficient of examples 1 and 2 has a larger absolute value than the Seebeck coefficient of comparative example 1 and 2. This shows that composites of the present invention are better at converting a temperature difference to electrical potential difference than comparative example 1 or comparative example 2.

Comparative example 1 shows the importance of including a thermoelectric material comprising a metal sulphosalt in the composite compared to having no thermoelectric material at all. In the absence of the thermoelectric material, in comparative example 1, the composite has a low absolute value for the Seebeck coefficient.

Comparative example 2 shows the benefit of including a thermoelectric material comprising a metal sulphosalt compared to including micaceous iron oxide filler. Micaceous iron oxide is a worse electrical conductor than the thermoelectric material comprising a metal sulphosalt used in Example 1 and Example 2. Additionally, micaceous iron oxide worsens the thermal performance, since micaceous iron oxide has a lamellar structure which makes it a better thermal conductor.

**Table 1**

| | Thermoelectric material | Electrically conductive polymer | Fibres | Binder | Seebeck coefficient, µV/K |
|---|---|---|---|---|---|
| Example 1 | 15g tetrahedrite-containing copper concentrate | 2.66g p-doped polypyrrole | 20g man-made vitreous fibres | 1.01g phenolic binder | -30.34 |
| Example 2 | 30g tetrahedrite-containing copper concentrate | 2.66g p-doped polypyrrole | 20g man-made vitreous fibres | 1.43g phenolic binder | -84.24 |
| Comparative example 1 | None | 3.75g p-doped polypyrrole | 62.5g man-made vitreous fibres | 3.98g phenolic binder | 3.66 |
| Comparative example 2 | 0.56g micaceous iron oxide | 3.18g p-doped polypyrrole | 62.5g man-made vitreous fibres | 3.97g phenolic binder | 1.16 |

### Examples 3 to 5

Conductive fibres were made by mixing the components listed in table 2.

**Table 2**

| Thermoelectric composite | Man-Made Vitreous Fibres (wt%) | Polymer (silicone resin) (wt%) | Filler (carbon black) (wt%) |
|---|---|---|---|
| Example 3 | 87,41 | 10,49 | 2,10 |
| Example 4 | 86,51 | 10,38 | 3,11 |
| Example 5 | 85,62 | 10,27 | 4,11 |

Test samples according to the invention were made by mixing the components as listed in table 3 in a mixer. After mixing, the mixture was subjected to a hot press to form a compact sample.

Compact samples were subjected to a hot press. The conditions used in examples 3-5 were 165°C and 102 kg/cm². Curing occurred over 8 hours at a temperature that increased from 25 to 170°C. The last hour of the cycle was at 170°C.

**Table 3**

| Thermoelectric Composite | Conductive fibre (wt%) | Tetrahedrite-containing copper concentrate (wt%) | Phenolic Binder (wt%) |
|---|---|---|---|
| Example 3 | 38,46 | 57,69 | 3,85 |
| Example 4 | 37,74 | 56,60 | 5,66 |
| Example 5 | 37,04 | 55,56 | 7,41 |

The current, voltage and resistivity were measured with a 20 °C temperature difference. Table 4 shows that both current and voltage were generated in Examples 3-5 of the present invention, showing the thermoelectric effect of the composite.

**Table 4**

| Thermoelectric composite | Current [mA] | Voltage at 20 ΔT [mV] | Resistivity [Ohm] |
|---|---|---|---|
| Example 3 | 4,00E-04 | 5 | 154000 |
| Example 4 | 0,0002 | 5 | 80000 |
| Example 5 | 0,0008 | 5 | 50000 |

## Claims

1. A composite comprising:
I. a thermoelectric material in the form of particles, wherein the particles have a diameter of 50 nm to 250 µm,
II. an electrically conductive polymer,
III. fibres,
wherein the thermoelectric material comprises a metal sulphosalt, wherein the metal sulphosalt comprises a compound comprising a metal, a semimetal and sulphur, wherein the fibres are at least partially coated with the electrically conductive polymer,
wherein the fibres act as a scaffold for the electrically conductive polymer to form a continuous electrically conductive network,
wherein the thermoelectric material is present in an amount of 5 to 70 wt% of the composite.

2. The composite of claim 1, wherein the metal sulphosalt comprises a copper or silver sulphosalt or mixture thereof, preferably a copper sulphosalt.

3. The composite of claim 1 or claim 2, wherein the semimetal is selected from antimony, arsenic, tellurium, germanium, silicon, boron, or a mixture thereof, preferably antimony, arsenic or a mixture thereof, preferably antimony.

4. The composite of any preceding claim, wherein the metal sulphosalt comprises tetrahedrite of the formula Cu₁₂₋ₓMₓSb_{4-y}As_{y}S₁₃, wherein 0 ≤ x ≤ 3, 0 ≤ y < 4 and M is Ag, Zn, Fe, Mn or combinations thereof.

5. The composite of any preceding claim, wherein the thermoelectric material comprises tetrahedrite of the formula Cu₁₂₋ₓMₓSb₄S₁₃, wherein 0 ≤ x ≤ 3 and M is Ag, Zn, Fe, Mn or combinations thereof.

6. The composite of any preceding claim, wherein the thermoelectric material is in the form of particles, wherein the particles have a diameter of 250 nm to 100 µm, preferably 10 to 50 µm.

7. The composite of any preceding claim, wherein the thermoelectric material is dispersed in the electrically conductive polymer.

8. The composite of any preceding claim, wherein the fibres are coated with the electrically conductive polymer.

9. The composite of any preceding claim, further comprising a binder.

10. The composite of any preceding claim, wherein the fibres are selected from synthetic inorganic fibres, natural inorganic fibres and carbon fibres, preferably the fibres are selected from synthetic inorganic fibres and more preferably the fibres are man-made vitreous fibres (MMVF).

11. A method of making a composite, comprising:
a. providing fibres,
b. providing an electrically conductive polymer,
c. providing a thermoelectric material in the form of particles, wherein the particles have a diameter of 50 nm to 250 µm, wherein the thermoelectric material comprises a metal sulphosalt, wherein the metal sulphosalt comprises a compound comprising a metal, a semimetal and sulphur,
d. optionally providing a binder,
e. mixing the fibres, the electrically conductive polymer, the thermoelectric material and the optional binder to form a mixture, such that the fibres are at least partially coated with the electrically conductive polymer, and
f. forming the mixture into a composite, wherein the thermoelectric material is present in an amount of 5 to 70 wt% of the composite, **characterised in that** the fibres act as a scaffold for the electrically conductive polymer to form a continuous electrically conductive network.

12. The method of claim 11, wherein step e comprises:
i. coating the fibres with the electrically conductive polymer to form coated fibres; and
ii. mixing the coated fibres with the thermoelectric material and optional binder.

13. The method of claim 11, wherein step e comprises
i. mixing the thermoelectric material and the electrically conductive polymer to form a dispersion of thermoelectric material in the electrically conductive polymer,
ii. coating the fibres with the dispersion to form coated fibres, and
iii. optionally mixing the coated fibres with the binder.

14. Use of the composite of any of claims 1 to 10 as a friction material, preferably wherein the friction material is an automotive friction material, more preferably wherein the friction material is a brake pad.

15. A thermoelectric device comprising the composite of any of claims 1 to 10, wherein the composite is disposed between a pair of conductors.

## Patentansprüche

1. Verbundwerkstoff, umfassend:
I. ein thermoelektrisches Material in Form von Partikeln, wobei die Partikel einen Durchmesser von 50 nm bis 250 µm haben,
II. ein elektrisch leitendes Polymer,
III. Fasern,
wobei das thermoelektrische Material ein Metallsulfosalz umfasst, wobei das Metallsulfosalz eine Verbindung umfasst, die ein Metall, ein Halbmetall und Schwefel umfasst, wobei die Fasern zumindest teilweise mit dem elektrisch leitenden Polymer beschichtet sind, wobei die Fasern als Gerüst für das elektrisch leitende Polymer wirken, um ein kontinuierliches, elektrisch leitendes Netzwerk zu bilden, wobei das thermoelektrische Material in einer Menge von 5 bis 70 Gew.-% des Verbundwerkstoffs vorhanden ist.

2. Verbundwerkstoff nach Anspruch 1, wobei das Metallsulfosalz ein Kupfer- oder Silbersulfosalz oder ein Gemisch daraus umfasst, vorzugsweise ein Kupfersulfosalz.

3. Verbundwerkstoff nach Anspruch 1 oder Anspruch 2, wobei das Halbmetall aus Antimon, Arsen, Tellur, Germanium, Silizium, Bor oder einem Gemisch davon ausgewählt ist, vorzugsweise aus Antimon, Arsen oder einem Gemisch davon, bevorzugt Antimon.

4. Verbundwerkstoff nach einem der vorhergehenden Ansprüche, wobei das Metallsulfosalz Tetrahedrit der Formel Cu₁₂₋ₓMₓSb_{4-y}As_{y}S₁₃ umfasst, wobei 0 ≤ x ≤ 3, 0 ≤ y < 4 und M Ag, Zn, Fe, Mn ist oder Kombinationen davon.

5. Verbundwerkstoff nach einem der vorhergehenden Ansprüche, wobei das thermoelektrische Material Tetrahedrit der Formel Cu₁₂₋ₓMₓSb₄S₁₃ umfasst, wobei 0 ≤ x ≤ 3 und M Ag, Zn, Fe, Mn ist oder Kombinationen davon.

6. Verbundwerkstoff nach einem der vorhergehenden Ansprüche, wobei das thermoelektrische Material in Form von Partikeln vorliegt, wobei die Partikel einen Durchmesser von 250 nm bis 100 µm, vorzugsweise von 10 bis 50 µm aufweisen.

7. Verbundwerkstoff nach einem der vorhergehenden Ansprüche, wobei das thermoelektrische Material in dem elektrisch leitenden Polymer dispergiert ist.

8. Verbundwerkstoff nach einem der vorhergehenden Ansprüche, wobei die Fasern mit dem elektrisch leitenden Polymer beschichtet sind.

9. Verbundwerkstoff nach einem der vorhergehenden Ansprüche, ferner ein Bindemittel umfassend.

10. Verbundwerkstoff nach einem der vorhergehenden Ansprüche, wobei die Fasern aus synthetischen anorganischen Fasern, natürlichen anorganischen Fasern und Kohlenstofffasern ausgewählt sind, wobei die Fasern vorzugsweise aus synthetischen anorganischen Fasern ausgewählt sind und die Fasern besonders bevorzugt aus künstlichen glasartigen Fasern (MMVF, man made vitrious fibres) ausgewählt sind.

11. Verfahren zum Herstellen eines Verbundwerkstoffs, umfassend:
a. Bereitstellung von Fasern,
b. Bereitstellen eines elektrisch leitenden Polymers,
c. Bereitstellen eines thermoelektrischen Materials in Form von Partikeln, wobei die Partikel einen Durchmesser von 50 nm bis 250 µm haben, wobei das thermoelektrische Material ein Metallsulfosalz umfasst, wobei das Metallsulfosalz eine Verbindung umfasst, die ein Metall, ein Halbmetall und Schwefel umfasst,
d. gegebenenfalls das Bereitstellen eines Bindemittels,
e. Mischen der Fasern, des elektrisch leitenden Polymers, des thermoelektrischen Materials und des optionalen Bindemittels, um ein Gemisch zu bilden, so dass die Fasern zumindest teilweise mit dem elektrisch leitenden Polymer beschichtet sind, und
f. Bilden des Gemisches zu einem Verbundwerkstoff, wobei das thermoelektrische Material in einer Menge von 5 bis 70 Gew.-% des Verbundwerkstoffs vorliegt, **dadurch gekennzeichnet, dass** die Fasern als Gerüst für das elektrisch leitende Polymer wirken, um ein kontinuierliches, elektrisch leitendes Netzwerk zu bilden.

12. Verfahren nach Anspruch 11, wobei der Schritt e umfasst:
i Beschichten der Fasern mit dem elektrisch leitenden Polymer, um beschichtete Fasern zu bilden; und
ii Mischen der beschichteten Fasern mit dem thermoelektrischen Material und dem optionalen Bindemittel.

13. Verfahren nach Anspruch 11, wobei der Schritt e umfasst:
i Mischen des thermoelektrischen Materials und des elektrisch leitenden Polymers, um eine Dispersion aus thermoelektrischem Material in dem elektrisch leitenden Polymer zu bilden,
ii Beschichten der Fasern mit der Dispersion, um beschichtete Fasern zu bilden, und
iii gegebenenfalls Mischen der beschichteten Fasern mit dem Bindemittel.

14. Verwenden des Verbundwerkstoffes nach einem der Ansprüche 1 bis 10 als Reibungsmaterial, wobei das Reibungsmaterial vorzugsweise ein Kraftfahrzeug-Reibungsmaterial ist, wobei das Reibungsmaterial insbesondere bevorzugt ein Bremsbelag ist.

15. Thermoelektrische Vorrichtung, die den Verbundwerkstoff nach einem der Ansprüche 1 bis 10 umfasst, wobei der Verbundwerkstoff zwischen einem Paar von Leitern angeordnet ist.

## Revendications

1. Composite comprenant :
I. un matériau thermoélectrique sous forme de particules, dans lequel les particules ont un diamètre de 50 nm à 250 µm,
II. un polymère électriquement conducteur,
III. des fibres,
dans lequel le matériau thermoélectrique comprend un sulfosel métallique, dans lequel le sulfosel métallique comprend un composé comprenant un métal, un semi-métal et du soufre, dans lequel les fibres sont au moins partiellement recouvertes du polymère électriquement conducteur, dans lequel les fibres agissent comme un échafaudage pour le polymère électriquement conducteur pour former un réseau électriquement conducteur continu, dans lequel le matériau thermoélectrique est présent en une quantité de 5 à 70 % en poids du composite.

2. Composite selon la revendication 1, dans lequel le sulfosel métallique comprend un sulfosel de cuivre ou d'argent ou un mélange de ceux-ci, de préférence un sulfosel de cuivre.

3. Composite selon la revendication 1 ou 2, dans lequel le semi-métal est choisi parmi l'antimoine, l'arsenic, le tellure, le germanium, le silicium, le bore, ou un mélange de ceux-ci, de préférence l'antimoine, l'arsenic ou un mélange de ceux-ci, de préférence l'antimoine.

4. Composite selon l'une quelconque des revendications précédentes, dans lequel le sulfosel métallique comprend du tétraédrite de formule Cu₁₂₋ₓMₓSb_{4-y}As_{y}S₁₃, dans laquelle 0 ≤ x ≤ 3, 0 ≤ y <4 et M représente Ag, Zn, Fe, Mn ou des combinaisons de ceux-ci.

5. Composite selon l'une quelconque des revendications précédentes, dans lequel le matériau thermoélectrique comprend du tétraédrite de formule Cu₁₂₋ₓMₓSb₄S₁₃, dans laquelle 0 ≤ x ≤ 3 et M représente Ag, Zn, Fe, Mn ou des combinaisons de ceux-ci.

6. Composite selon l'une quelconque des revendications précédentes, dans lequel le matériau thermoélectrique se présente sous la forme de particules, dans lequel les particules ont un diamètre de 250 nm à 100 µm, de préférence de 10 à 50 µm.

7. Composite selon l'une quelconque des revendications précédentes, dans lequel le matériau thermoélectrique est dispersé dans le polymère électriquement conducteur.

8. Composite selon l'une quelconque des revendications précédentes, dans lequel les fibres sont revêtues du polymère électriquement conducteur.

9. Composite selon l'une quelconque des revendications précédentes, comprenant en outre un liant.

10. Composite selon l'une quelconque des revendications précédentes, dans lequel les fibres sont choisies parmi des fibres inorganiques synthétiques, des fibres minérales naturelles et des fibres de carbone, de préférence, les fibres sont choisies parmi des fibres inorganiques synthétiques, et plus préférablement, les fibres sont des fibres vitreuses artificielles (FVA).

11. Procédé de fabrication d'un composite, comprenant :
a. la fourniture de fibres,
b. la fourniture d'un polymère électriquement conducteur,
c. la fourniture d'un matériau thermoélectrique sous forme de particules, dans lequel les particules ont un diamètre de 50 nm à 250 µm, dans lequel le matériau thermoélectrique comprend un sulfosel métallique, dans lequel le sulfosel métallique comprend un composé comprenant un métal, un semi-métal et du soufre,
d. éventuellement la fourniture d'un liant,
e. le mélange des fibres, du polymère électriquement conducteur, du matériau thermoélectrique et du liant facultatif pour former un mélange, de sorte que les fibres sont au moins partiellement revêtues du polymère électriquement conducteur, et
f. la formation du mélange en un composite, dans lequel le matériau thermoélectrique est présent en une quantité de 5 à 70 % en poids du composite, **caractérisé en ce que** les fibres agissent comme un échafaudage pour le polymère électriquement conducteur pour former un réseau électriquement conducteur continu.

12. Procédé selon la revendication 11, dans lequel l'étape e comprend :
i le revêtement des fibres du polymère électriquement conducteur pour former des fibres revêtues ; et
ii le mélange des fibres revêtues du matériau thermoélectrique et du liant facultatif.

13. Procédé selon la revendication 11, dans lequel l'étape e comprend
i le mélange du matériau thermoélectrique et du polymère électriquement conducteur pour former une dispersion de matériau thermoélectrique dans le polymère électriquement conducteur,
ii le revêtement des fibres de la dispersion pour former des fibres revêtues, et
iii éventuellement le mélange des fibres revêtues du liant.

14. Utilisation du composite selon l'une quelconque des revendications 1 à 10 comme matériau de friction, de préférence dans lequel le matériau de friction est un matériau de friction automobile, plus préférablement dans lequel le matériau de friction est une plaquette de frein.

15. Dispositif thermoélectrique comprenant le composite selon l'une quelconque des revendications 1 à 10, dans lequel le composite est disposé entre une paire de conducteurs.
